Europäisches Patentamt

(19) European Patent Office

Office européen des brevets

(11) Veröffentlichungsnummer: **0 012 956**
**B1**

(12) **EUROPÄISCHE PATENTSCHRIFT**

(45) Veröffentlichungstag der Patentschrift:
**13.04.83**

(51) Int. Cl.³: **G 03 F 7/02**

(21) Anmeldenummer: **79105181.6**

(22) Anmeldetag: **14.12.79**

(54) **Verfahren zum Herstellen von Flachdruckformen.**

(30) Priorität: **21.12.78 DE 2855393**

(43) Veröffentlichungstag der Anmeldung:
**09.07.80 Patentblatt 80/14**

(45) Bekanntmachung des Hinweises auf die Patenterteilung:
**13.04.83 Patentblatt 83/15**

(84) Benannte Vertragsstaaten:
**AT BE CH DE FR GB IT NL SE**

(56) Entgegenhaltungen:
**DE-A-1 447 963**
**DE-A-2 530 422**
**DE-A-2 626 473**
**DE-B-1 121 632**
**GB-A-1 482 351**

(73) Patentinhaber: **HOECHST AKTIENGESELLSCHAFT,**
**Postfach 80 03 20, D-6230 Frankfurt/Main 80 (DE)**

(72) Erfinder: **Schell, Loni, Erbacher Strasse 10,**
**D-6238 Hofheim-Wallau (DE)**

BUNDESDRUCKEREI BERLIN

## Verfahren zum Herstellen von Flachdruckformen

Die Erfindung betrifft ein Verfahren zum Herstellen von Flachdruckformen hoher Leistung bezüglich Auflage und Tonwertkonstanz beim Druck.

Wie aus der DE-OS 1 447 963 bekannt ist, kann die Druckauflage und Qualität durch Erhitzen der kopierten Platte auf hohe Temperaturen von 180° C bis 240° C gesteigert werden.

Bei diesem Einbrennverfahren treten Rückstände in den Nichtbildbereichen auf. Sie werden nach Angaben der DE-OS 1 447 963 durch Nachbehandeln mit einer alkalischen oder sauren Lösung, z. B. mit Flußsäure oder Trinatriumphosphat, entfernt.

Ein Nachteil der Behandlung mit Flußsäure ist die Gesundheitsschädlichkeit. Trinatriumphosphat in der benötigten Konzentration greift die anodisch erzeugte Oxidschicht von Aluminiumträgern an, die zur Erzielung hoher Druckauflagen allgemein verwendet werden.

Die Methode der Nachbehandlung von eingebrannten Offsetplatten, wie sie in der DE-PS 854 890 für harzfreie Diazo-Schichten beschrieben ist, z. B. mit 1%iger Phosphorsäure, führt bei Schichtzusammensetzungen, wie sie nach heutigem Stand der Technik zur Herstellung von Hochleistungsdruckformen verwendet werden, nicht zu befriedigenden Ergebnissen.

Die DE-OS 2 626 473 beschreibt ein Verfahren, das darin besteht, daß man vor dem Einbrennen eine wäßrige Lösung aufträgt. Die wirksamsten Mittel dieser Art sind Lösungen von sulfonsauren Salzen, die Netzmittelcharakter haben. Hier besteht aber die Gefahr, daß die Platte nach dem Einbrennen nicht ausreichend abgespült wird und dadurch anhaftende Netzmittel den Druckablauf stören. Anorganische Salze, vor dem Einbrennen aufgetragen, führen vielfach zu Fleckenbildung auf der Druckschablone. Das Verfahren ist relativ zeitaufwendig, da das Auftragen zumeist unter Trockenreiben erfolgt.

Aufgabe der Erfindung war es, ein Verfahren zu finden, bei dem sich der beim Einbrennen von Flachdruckformen entstehende Niederschlag leicht, wirksam, mit geringem Arbeitsaufwand und unter weitgehender Schonung der Trägeroberfläche entfernen läßt.

Die Erfindung geht aus von einem Verfahren zum Herstellen von Flachdruckformen, bei dem ein lichtempfindliches Material aus einem Schichtträger mit hydrophiler Oberfläche und einer lichtempfindlichen Schicht, die ein 1,2-Naphthochinondiazid enthält, bildmäßig belichtet, entwickelt und dann auf eine Temperatur oberhalb 180° C so lange und so hoch erhitzt wird, daß eine Zersetzung der farbführenden Bildteile eintritt und auf dem hydrophilen Bilduntergrund ein oleophiler Niederschlag entsteht, und danach der Niederschlag durch Behandeln mit einer wäßrigen Lösung entfernt wird.

Das erfindungsgemäße Verfahren ist dadurch gekennzeichnet, daß man zum Entfernen des Niederschlags eine wäßrige Lösung von 0,01 bis 50 Gew.-% Polyvinylphosphonsäure verwendet.

Lösungen von Polyvinylphosphonsäuren sind bereits aus der DE-B-1 121 632 als Feucht- und Reinigungsmittel für das Offsetdruckverfahren bekannt.

Gemäß einer besonderen Ausführungsform des Verfahrens kann man der Nachbehandlungslösung zusätzlich ein wasserlösliches Polymeres, z. B. Gummi arabicum oder Polyvinylalkohol, zusetzen und dadurch zugleich mit der Reinigung eine Konservierung der Oberfläche der Druckform durchführen. Das Polymere wird in der für Konservierungslösungen üblichen Menge, zweckmäßig von etwa 2 bis 40, vorzugsweise 5 bis 20 Gew.-%, zugesetzt.

Die Polyvinylphosphonsäure kann Molekulargewichte innerhalb weiter Bereiche haben. Als besonders wirksam haben sich solche Polyvinylphosphonsäuren erwiesen, deren 33%ige wäßrige Lösungen bei 20° C Viskositäten von etwa 50 bis 220 mPa · s haben.

Obwohl die Konzentration der Polyvinylphosphonsäure im ganzen oben angegebenen Bereich und auch darüber liegen kann, werden im allgemeinen aus Kostengründen verdünntere Lösungen, etwa im Bereich von 0,05 bis 25 Gew.-%, bevorzugt.

Die Anwendung der Lösung erfolgt in üblicher Weise z. B. durch Überwischen, Reiben, Bürsten oder Sprühen. Wenn danach sofort von der Platte gedruckt werden soll, wird die Behandlungslösung mit Wasser abgespült. Wenn die Platte zugleich konserviert werden soll, wird im allgemeinen die Lösung in üblicher Weise auf der Oberfläche getrocknet.

Als lichtempfindliche Materialien, die sich mit Vorteil nach dem erfindungsgemäßen Verfahren verarbeiten lassen, sind alle positiv arbeitenden Materialien mit o-Chinondiaziden, insbesondere Naphthochinon-(1,2)-diaziden, geeignet. Die lichtempfindlichen Schichten der Materialien enthalten ferner in bekannter Weise alkalilösliche Harze, insbesondere Phenolharz-Novolake, zweckmäßig in einer Menge von 1 bis 10 Gewichtsteilen je Gewichtsteil an o-Chinondiazid. Geeignete Materialien sind z. B. in den DE-OS 1 447 963, 2 331 377, 2 547 905, 2 718 259 und der DE-PS 938 233 beschrieben.

Als Trägermaterialien sind insbesondere Aluminiumfolien geeignet, die mechanisch, chemisch oder elektrolytisch aufgerauht sind. Bevorzugt werden Aluminiumfolien, die zusätzlich eine anodisch erzeugte Oxidschicht tragen, da mit ihnen besonders hohe Druckauflagen erreicht werden.

Die Verarbeitung der Materialien erfolgt, abgesehen von dem Schritt der Nachbehandlung mit Polyvinylphosphonsäurelösung, in bekannter Weise, wie es z. B. in der DE-OS 1 447 963 beschrieben ist.

**0 012 956**

Die folgenden Beispiele erläutern vorteilhafte Ausführungsformen des Verfahrens. Prozentangaben und Mengenverhältnisse sind in Gewichtseinheiten zu verstehen, wenn nichts anderes angegeben ist.

## Beispiel

Mit einer Lösung von

| | |
|---|---|
| 2,17 g | des 4-($\alpha,\alpha$-Dimethyl-benzyl)-phenylesters der Naphthochinon-(1,2)-diazid-(2)-4-sulfonsäure, |
| 1,02 g | des Veresterungsproduktes aus 1 Mol 2,2'-Dihydroxy-dinaphthyl-(1,1')-methan und 2 Mol Naphthochinon-(1,2)-diazid-(2)-5-sulfonsäurechlorid, |
| 0,37 g | Naphthochinon-(1,2)-diazid-(2)-4-sulfonsäurechlorid, |
| 0,12 g | Kristallviolettbase und |
| 9,90 g | Kresol-Formaldehyd-Novolak (Erweichungspunkt 112—118° C) |

in

| | |
|---|---|
| 55 ccm | Tetrahydrofuran, |
| 45 ccm | Äthylenglykolmonomethyläther, |
| 11 ccm | Butylacetat |

wird eine elektrochemisch aufgerauhte und anodisierte Aluminiumfolie (3 g Aluminiumoxid/m²) beschichtet, so daß nach dem Trocknen ein Schichtgewicht von 3,8 g/m² resultiert.

Die Platte wird unter einer Positiv-Vorlage 1,5 Minuten belichtet (Ozasol Belichtungsanlage Violight/BA 578 5 kW—Abstand 1 m), mit einer 5%igen Natriummetasilikatnonahydrat-Lösung entwickelt, mit Wasser abgespült, abgerakelt, an der Luft getrocknet und in einem Ofen 10 Minuten auf 240° C erhitzt. Nach dem Abkühlen wird die Platte mit einer 10%igen wäßrigen Lösung von Polyvinylphosphonsäure leicht und gleichmäßig überwischt, mit Wasser abgespült und konserviert.

Die Konservierung wird in der Druckmaschine mit einem feuchten Schwamm abgewischt, die Platte liefert nun tonfreie Drucke mit sehr hoher Auflage.

Behandelt man statt mit Polyvinylphosphonsäure mit einer 10%igen Lösung von Polyvinylsulfonsäure und hält die übrigen Arbeitsschritte gleich, so tont die Platte in der Druckmaschine.

Verfährt man in bisher üblicher Weise, d. h. behandelt man nach dem Einbrennen 2 Minuten lang mit 5%iger Trinatrium-phosphatdodekahydrat-Lösung, so tritt bei dem verwendeten elektrochemisch aufgerauhten und anodisierten Träger ein Gewichtsverlust von 2,35 g/m² auf, d. h. die Oxidschicht des Trägermaterials wird stark angegriffen, die optimale Wasserführung und Druckauflage ist nicht mehr gewährleistet.

Dieser Mangel tritt bei der erfindungsgemäßen Behandlungslösung nicht auf.

## Beispiel 2

Man stellt eine Offsetdruckplatte nach Beispiel 1 her und brennt 10 Minuten bei 230° C ein. Man behandelt diese Platte mit einer Lösung folgender Zusammensetzung:

| | |
|---|---|
| 16 g | Polyvinylalkohol mit einer Viskosität von 4 mPa · s in 4%iger wäßriger Lösung bei 20° C und einem Restacetylgehalt von 10,7%, |
| 14 g | gelbes Kartoffeldextrin, vollständig wasserlöslich, Ostwald-Viskosität = 2,80; pH-Wert 2,8, |
| 30 g | Polyvinylphosphonsäure in |
| 240 g | Wasser. |

Die Lösung wird als Konservierungsmittel auf der Plattenoberfläche trocknen gelassen.

Nach Tagen, bei Bedarf wischt man die Platte mit einem feuchten Schwamm in der Druckmaschine ab und erhält einwandfreie Drucke. Bei diesem Verfahren spart man einen zusätzlichen Arbeitsschritt, um die Platte von den Einbrennrückständen zu befreien.

## Beispiel 3

Mit einer Lösung aus

| | |
|---|---|
| 1,5 g | des Kondensationsproduktes aus 1 Mol 2,3,4-Trihydroxy-benzophenon und 1 Mol Naphthochinon-(1,2)-diazid-(2)-5-sulfonsäurechlorid, |

3

0,8 g des Kondensationsproduktes aus 1 Mol 2,2'-Dihydroxy-1,1'-dinaphthylmethan und 2 Mol 1,2-Naphthochinondiazid-(2)-5-sulfonsäurechlorid,

6 g des in Beispiel 1 angegebenen Novolaks und

120 ccm Äthylenglykolmonomethyläther

wird eine mechanisch aufgerauhte Aluminiumfolie so beschichtet, daß ein Schichtgewicht von 1,15 g/m² resultiert.

Die Platte wird 1 Minute belichtet, wie in Beispiel 1 entwickelt, 10 Minuten bei 240° C eingebrannt und mit einer wäßrigen Lösung, die 0,5% Polyvinylphosphonsäure und 15% Gummi arabicum enthält, überwischt. Die Lösung wird auf der Platte getrocknet und nach etwa 1 bis 2 Tagen Lagerung oder länger in der Druckmaschine mit feuchtem Schwamm entfernt.

Man erhält tonfreie Drucke.

## Beispiel 4

Eine lichtempfindliche Druckplatte, wie in Beispiel 1 hergestellt, wird wie dort belichtet und entwickelt. Sie wird dann 10 Minuten bei 240° C eingebrannt und mit einer 40%igen wäßrigen Lösung von Polyvinylphosphonsäure überwischt. Die Lösung spült man dann mit Wasser ab, rakelt ab und konserviert mit einer Lösung von 10% Polyvinylalkohol und 5% Dextrin.

Man erhält einwandfreie, tonfreie Drucke.

Behandelt man dagegen mit 1%iger Phosphorsäure wie in Beispiel 7 der DE-PS 854 890 beschrieben, so ist der Druck nicht tonfrei.

## Beispiel 5

Eine Druckplatte wird wie in Beispiel 1 hergestellt und 10 Minuten bei 240° C eingebrannt. Nach dem Abkühlen wird sie mit 0,1%iger Polyvinylphosphonsäure überwischt. Die Lösung wird dann abgespült, abgerakelt und mit einer Dextrinlösung konserviert oder direkt in die Druckmaschine eingespannt.

Man erhält tonfreie Drucke.

## Patentansprüche

1. Verfahren zum Herstellen von Flachdruckformen, bei dem ein lichtempfindliches Material aus einem Schichtträger mit hydrophiler Oberfläche und einer lichtempfindlichen Schicht, die ein 1,2-Naphthochinondiazid enthält, bildmäßig belichtet, entwickelt und dann auf eine Temperatur oberhalb 180° C so lange und so hoch erhitzt wird, daß eine Zersetzung der farbführenden Bildteile eintritt und auf dem hydrophilen Bilduntergrund ein oleophiler Niederschlag entsteht und danach der Niederschlag durch Behandeln mit einer wäßrigen Lösung entfernt wird, dadurch gekennzeichnet, daß man zum Entfernen des Niederschlags eine wäßrige Lösung von 0,01 bis 50 Gew.-% Polyvinylphosphonsäure verwendet.

2. Verfahren nach Anspruch 1, dadurch gekennzeichnet, daß man zum Entfernen des Niederschlags eine Lösung verwendet, die zusätzlich ein wasserlösliches, zur Konservierung der Platte geeignetes Polymeres enthält.

## Claims

1. A process for the preparation of planographic printing forms, in which a light-sensitive material composed of a support having a hydrophilic surface and of a light-sensitive layer, which contains a 1,2-naphthoquinone-diazide, is exposed imagewise, developed and then heated to a temperature above 180° C for such a time and at such a temperature level that decomposition of the ink-carrying image parts takes place and an oleophilic precipitate is formed on the hydrophilic image background, and the precipitate is then removed by treatment with an aqueous solution, characterized in that an aqueous solution of 0.1 to 50% by weight of polyvinyl phosphonic acid is used for the removal of the precipitate.

2. A process as claimed in claim 1 wherein the solution used for the removal of the precipitate additionally contains a water-soluble polymer which is suitable for preserving the plate.

**Revendications**

1. Procédé pour la fabrication de plaques lithographiques, dans lequel un matériel photosensible comprenant un support de couche ayant une surface hydrophile et une couche photosensible renfermant un 1,2-naphtoquinone-diazide, est exposé à la lumière selon une image, développé, puis chauffé au-dessus de 180°C pendant un temps et à une température tels qu'il se produise une décomposition des zones colorées de l'image et qu'il se forme un précipité oléophile sur le fond hydrophile de l'image, après quoi on enlève le précipité par traitement au moyen d'une solution aqueuse, caractérisé en ce que, pour enlever le précipité, on utilise une solution aqueuse contenant entre 0,01 et 50% en poids d'acide polyvinylphosphonique.

2. Procédé selon la revendication 1 caractérisé en ce que, pour enlever le précipité, on utilise une solution contenant en outre un polymère hydrosoluble, qui convient à la conservation de la plaque.